# EUROPEAN PATENT SPECIFICATION

(11) **EP 0 285 662 B1**
(45) Date of publication and mention of the grant of the patent: **30.11.1994**
(21) Application number: 87905794.1
(22) Date of filing: 09.09.1987
(51) Int. Cl.: G01D 5/245

(54) **DIGITAL PULSE CIRCUIT**
SCHALTUNG FÜR DIGITALE IMPULSE
CIRCUIT A IMPULSIONS NUMERIQUES

(30) Priority: 10.09.1986 JP 211718/86
(43) Date of publication of application: 12.10.1988
(73) Proprietor: FANUC LTD., Minamitsuru-gun, Yamanashi 401-05 (JP)
(72) Inventor: KOBARI, Katsuo, Tachikawa-shi Tokyo 190 (JP); TAKEKOSHI, Yoshitaka, 432, Terada-cho Hachioji-shi Tokyo 193 (JP); TANIGUCHI, Mitsuyuki, Hino-shi Tokyo 191 (JP)
(74) Representative: Brunner, Michael John
(86) International application number: PCT/JP87/00666
(87) International publication number: WO 88/02104

(56) References cited:
- EP-A- 0 076 861
- JP-A- 5 927 221
- JP-U-55 123 818

## Description

The present invention relates to a digital pulse circuit. More particularly, it relates to a digital pulse circuit for maintaining a pulse width and for suppressing noises.

The present invention is particularly advantageously used in a high-resolution pulse encoder circuit.

Pulse encoders are used for precise position detection in numerical control (NC) apparatus or the like.

In general, two types of pulse encoders are known; an incremental type and an absolute type. Recently, incremental type pulse encoders having a simple constitution and functioning substantially as an absolute type, have been proposed. (Cf. JPA No.60-218027, and No.218029)

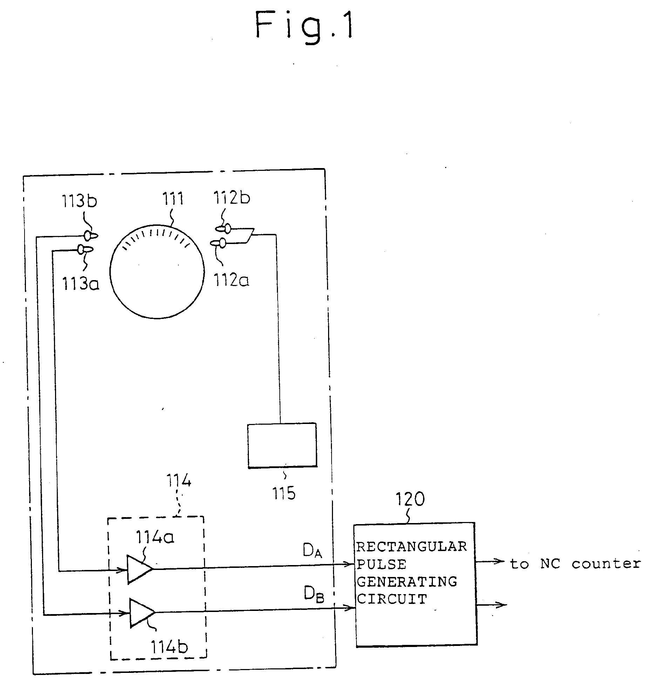

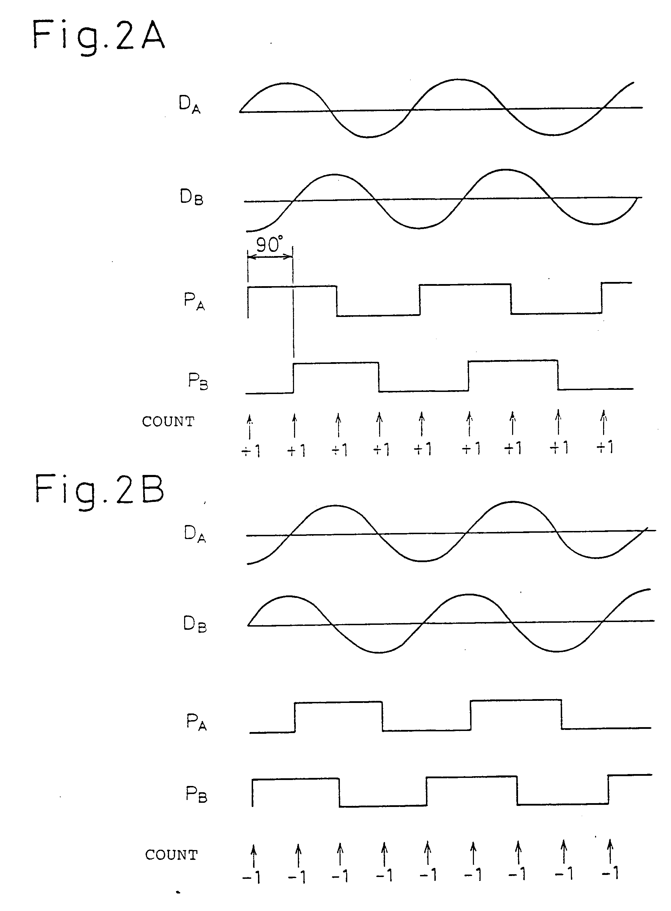

As shown in Fig.1, the pulse encoder as mentioned above has a rotating code disc 111 which is fixed to a rotation axle which rotates in correspondence with a motion of an object and accordingly which rotates with the rotation axle. The pulse encoder is provided with a pair of light-emitting devices 112a,112b and a pair of light-detecting devices 113a,113b, at the both side of the rotating code disc 111. And each of the light-emitting devices 112a,112b and the corresponding light-detecting devices 113a, 113b confront each other with the rotating code disc 111 intervening therebetween. The circumference of the rotating code disc 111 is provided with translucent parts and non-translucent parts, and when the rotating code disc 111 is rotated, light emitted from the light-emitting devices 112a, 112b passes in part through the translucent parts of the rotating code disc 111 and is transformed to A-phase signal and B-phase signals, where the phase of B-phase signal differs by 90 ° from the phase of the A-phase signal. These signals then become sine wave signals D _{A} and D _{B} (as shown in Fig.2A and Fig.2B) at light-detecting device output amplifiers 114a and 114b, respectively. The A-phase signal precedes the B-phase signal by 90 ° in phase when the rotating code disc 111 rotates in the positive direction (as shown in Fig.2A), and the B-phase signal precedes the A-phase signal by 90° in phase when the rotating code disc 111 rotates in the negative direction (as shown in Fig.2B). The above sine wave signals D _{A} and D _{B} enter the rectangular pulse generating circuit 120. The rectangular pulse generating circuit 120, for example, is provided with a comparator for comparing the level of input signals with a predetermined threshold level, and thus, rectangular pulses P _{A} and P _{B} as shown in Fig. 2A and Fig.2B are obtained. The counter in NC apparatus detects the direction of the rotating code disc 111, namely, the counter determines the direction of motion of the object by the sign of the phase-difference between the above pulses P _{A} and P _{B} , and at every timing of leading (rising) edge and trailing (falling) edge of the pulses P _{A} and P _{B} , the count of the counter in NC apparatus is incremented if the positive direction is determined and is decremented if the negative direction is determined.

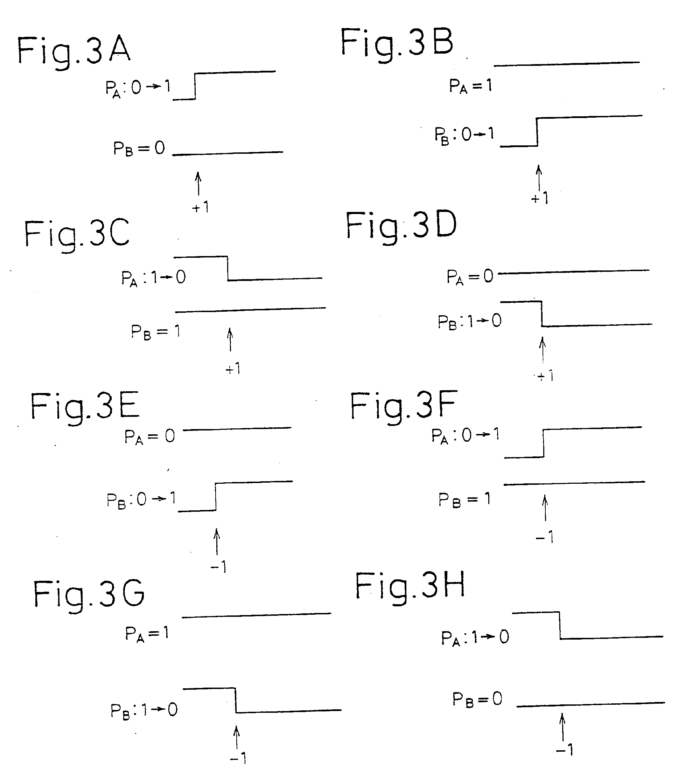

Figures 3A-3H show the manner of counting at the counter in NC apparatus as mentioned above. The counting ( ±1) is made according to a combination of the level of one of the A-phase signal and the B-phase signal, and the direction of the transition of the level (leading edge or trailing edge of the pulses) in the other of the A-phase signal and B-phase signal.

To obtain position-measurement information with a high resolution, first, a series of sine waves, each having a different phase and the phase of the succeeding wave being delayed by an constant phase difference from the preceding wave, are obtained from the aforementioned sine waves D _{A} and D _{B} , and the series of sine waves are applied to the aforementioned rectangular pulse generating circuit to obtain rectangular pulses with the abovementioned phase difference.

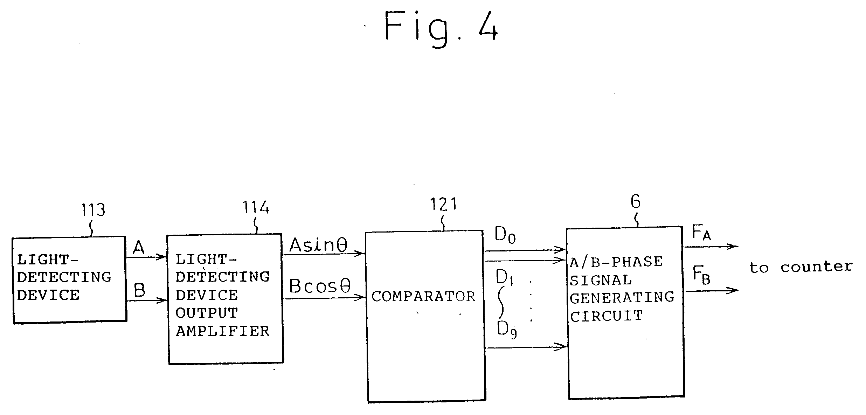

Figure 4 shows a construction of an apparatus used to execute the abovementioned procedure.

The apparatus consists of light-detecting devices 113 similar to the aforementioned light-detecting devices 113a, 113b, a light-detecting device output amplifiers 114, a comparator 121 for obtaining rectangular pulses with the aforementioned phase difference, a A/B-phase signal generating circuit 6 which transforms the rectangular pulses to A-phase and B-phase signals, with a 90 ° phase difference between one signal and another.

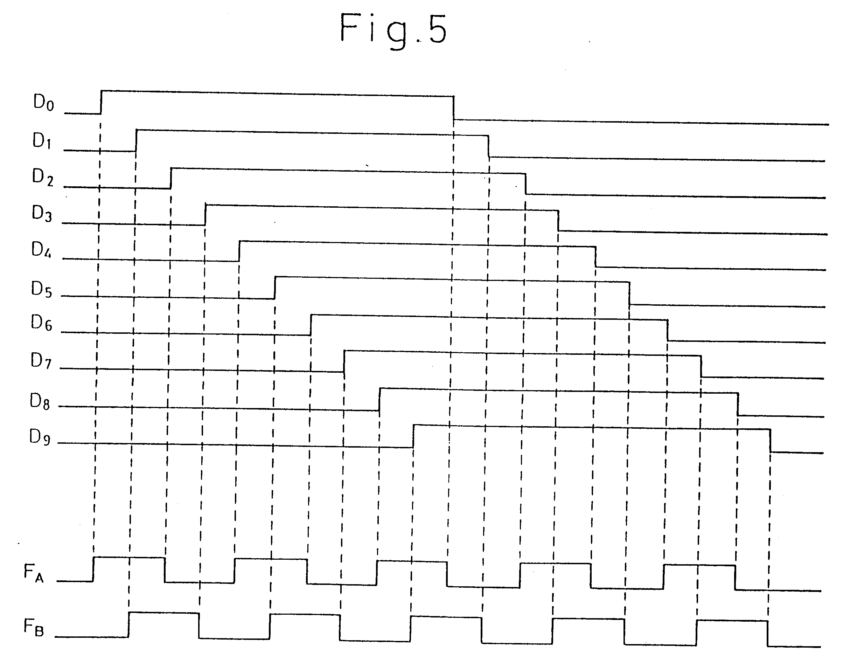

By using the abovementioned apparatus and obtaining ten rectangular pulses, the phase of each pulse of which is delayed by 1/10 2/10, ···9/10 of the half cycle time of the aforementioned signals D_{A} or D_{B} (the pulse width of P_{A} and P_{B} ) from the signals D_{A} and D_{B} , respectively, the inventers formerly obtained a five times greater resolution than the resolution obtained by merely counting the aforementioned rectangular pulses shown in Figs.2A and 2B. Generally, when N is an even number, by obtaining a set of N rectangular pulses the phase of each pulse which is delayed from the aforementioned signals D_{A} and D_{B} by 1/N, 2/N, ··· N-1/N of the half cycle time of the signals D_{A} or D_{B} , an N/2 times greater resolution than obtained by counting the aforementioned rectangular pulses shown in Figs.2A and 2B, can be obtained, using the abovementioned apparatus. Figure 5 shows the set of ten rectangular pulses D₀,··· D₉ mentioned above.

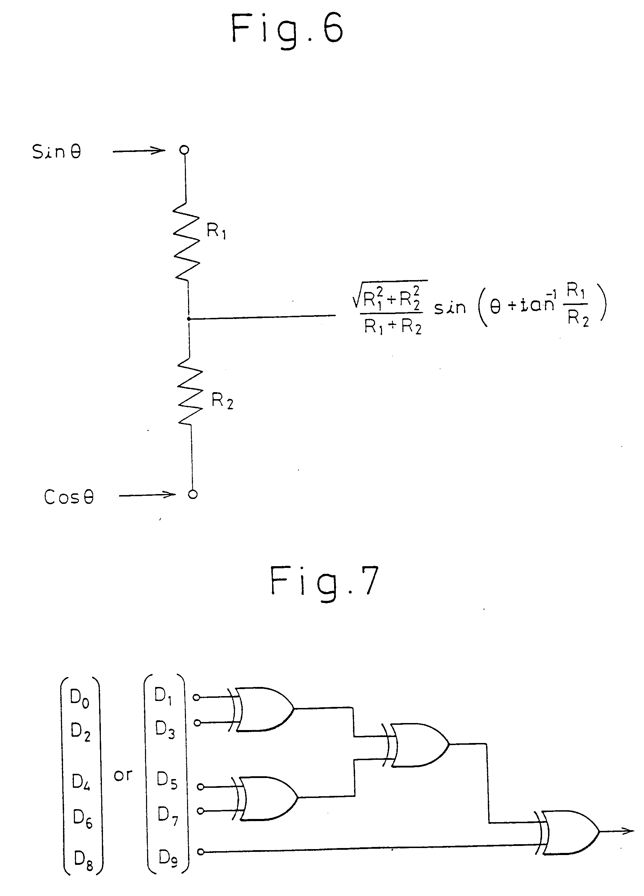

For example, obtaining sine waves having phases preceding (or delayed from) the aforementioned signals D _{A} and D_{B} by an arbitrary constant phase, is made possible by the construction shown in Fig.6, i.e., when sin ϑ is applied to one terminal of the series connection of resisters R₁ and R₂, and sin (ϑ + π/2)= cos ϑ is applied to another terminal of the series connection of resisters R₁ and R₂, the level of the connecting point of the resisters R₁ and R₂ becomes (R₁² +R₂²)^{½}sin (ϑ+ tan ⁻¹R₁/R₂)/(R₁+R₂). This means that a sine wave with an arbitrary phase difference can be obtained when the resistance values of resistors R₁ and R₂ are suitably selected.

The ten pulses D₀,··· D₉ obtained as mentioned above (Fig.5) are transformed to the two rectangular A-phase and B-phase pulses having a phase difference of 90 ° , so that a high resolution reading of a position measurement at the NC apparatus side becomes possible. These two rectangular A-phase and B-phase pulses can be obtained by the construction as shown in Fig.7. The A-phase pulse F_{A} is obtained by applying each of D₀, D₂, D₄, D₆, D₈ to five input terminals of the construction of Fig.7, respectively and the B-phase pulse F_{B} is obtained by applying each of D₁, D₃, D₅, D₇, D₉ to the five input terminals of the construction of Fig. 7, respectively (Fig.5). Figure 5 shows the timing relationship of these signals F_{A} and F_{B} and the abovementioned D₀, ··· D₉.

However, in general, the amplitudes of the output sine waves D_{A} and D_{B} are not exactly equal, and these include offset voltages resulting from the light-detecting device or amplifier. In addition, the phase difference between D _{A} and D _{B} is not exactly 90 ° , i. e., there is some error in the phase difference between D_{A} and D_{B} due to an error in the production of each slit, relative position of the light-emitting devices 112a,112b and the light-detecting devices, or delay time of the light-detecting devices or the like.

The abovementioned errors in the sine waves D _{A} and D _{B} and the phase difference between D _{A} and D _{B} have a large influence on the result when these two sine waves are transformed to the aforementioned N rectangular pulses. In this case, the above errors cause some changes in the timings of the leading edges or tailing edges among D₀, ··· D₉, and changes in the time intervals between any two of the leading edges and tailing edges.

However, the NC apparatus which receives the aforementioned rectangular pulses F_{A} and F_{B} and which should count the leading edges and tailing edges, can not count same when the time interval between any leading edge and tailing edge of the rectangular pulses F _{A} and F _{B} becomes less than the limit (minimum countable time interval) τ ₀ determined by the cycle time of the reading clock in the NC apparatus (about 300nsec).

Especially, in case of a high speed rotation, due to fluctuations in the aforementioned time intervals between the leading edges and tailing edges of the rectangular pulses F _{A} and F _{B} , the time intervals may become less than the limit τ ₀.

Another problem comes from noise.

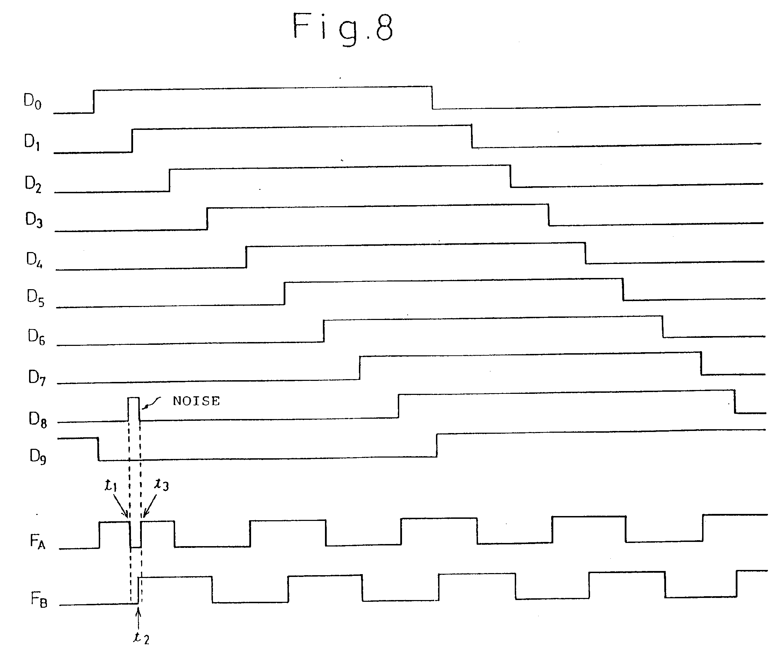

As mentioned before, in the prior art, the rectangular pulses F _{A} and F _{B} are obtained as an output of the pulse encoder, by applying the set of D₀, D₂, D₄, D₆, D₈ or the set of D₁, D₃, D₅, D₇, D₉ to the logic circuit of Fig.7. Therefore, for example, when noise appears even in only one input signal among D₀, D₁, ··· D₉, the noise causes an influence directly on the output pulse F_{A} or F_{B} . As shown in Fig.8, when a noise appears in the signal D₈, which properly must be zero during the time interval between a leading edge of D₀ and a leading edge of D₂, an abnormal notch appears in the shape of F _{A} , through the construction of Fig.7 as mentioned before. If the timing of the leading edge of F_{B} is in the time interval where F_{A} is low level due to the abovementioned noise, the NC apparatus counts "-1", judging the motion of the objective to be in the negative direction at the timing t₁, because F_{A} rises due to the noise while F_{B} is low level (cf.Fig.3H). Then the NC apparatus counts "-1", judging that the motion of the objective to be in the negative direction again at the timing t₂, because F _{B} rises while F _{A} is low level due to the noise (cf.Fig.3E), and the NC apparatus counts "-1", judging the motion of the objective to be in the negative direction once again at the timing t₃, because F _{A} rises due to the noise while F _{B} is low (cf.Fig.3E). If the noise mentioned above does not appear in the signal D₈, during the interval covering the abovementioned timings t₁, t₂, and t₃, the NC apparatus must count "+1" once, judging the motion of the objective to be in the positive direction at the timing t₂, because F _{B} rises while F _{A} is high level. However, when noise appears, the NC apparatus counts "-3" during the same interval. This means that, in the high-resolution pulse encoders of the prior art, an incorrect result may be output due to the deformation in the output wave from the light-detecting device or noise which is superposed on the digital signals.

An object of the present invention is to provide a digital pulse circuit for deriving information by incremental pulses from waves output by a light-detecting device in a high-resolution pulse encoder, relating to an objective quantity to be measured, in which the time intervals between incremental pulses are maintained as equal to or longer than the minimum countable time interval in the apparatus which counts the output of the pulse encoder, and in which noise superposed on digital signals has no influence on the information relating to an objective quantity to be measured.

EP-A-0076861, over which the present invention is characterised, discloses a digital signal synchronizer.

According to the present invention, there is provided a digital pulse circuit which receives N input digital signals in parallel, where N is an even integer equal to or greater than 4, the circuit comprising: a clock pulse generator (7) which generates a clock pulse having a predetermined cycle time; and, first means for accepting the N input digital signals, synchronising each of the N input digital signals with the clock pulse, and holding the level of each signal until a new signal is accepted, to output N synchronised digital signals; characterised by:
second means for enabling only two of said N input digital signals to be accepted by the first means in each clock cycle, said two digital signals being determined based on the immediately preceding levels of the N synchronised digital signals.

With the above mentioned construction, the present invention permits the output pulses from a high resolution encoder to be maintained at time intervals of not less than the minimum countable time at the counter, and to suppress noise.

### BRIEF DISCRIPTION OF DRAWINGS

Figure 1 shows the most basic composition of pulse encoder of the prior art;
Fig.2A and Fig.2B show the shapes of the output waves of the pulse encoder in Fig.1;
Figs.3A-3H show the manner of counting the outputs of the pulse encoder in the counter;
Fig.4 shows the construction of the high resolution pulse encoder of the prior art;
Fig.5 shows the shapes of the output waves of the comparators in Fig.4 and Fig.9, and the shapes of the output waves of the A/B-phase signal generating circuit;
Fig.6 shows the principle of generating the sine wave having an arbitrary phase difference in the comparators in Fig.5 and Fig.8;
Fig.7 shows the construction of the A/B-phase signal generating circuit in Fig.5 and Fig.8;
Fig.8 shows the influence on the shape of the output by noise in the pulse encoder circuit of the composition of Fig.4;
Fig.9 shows the construction for maintaining a pulse width and suppressing noise according to the present invention;
Fig.10 shows an example of the construction of the digital pulse circuit for maintaining a pulse width and suppressing noise according to the first aspect of the present invention;
Fig.11A and Fig.11B show an example of the construction of the enable signal output portion 2 in Fig.10 and Fig.14;
Fig.12 shows the operation of the circuit in Fig. 10;
Fig.13 shows an abnormal case which can occurs in the digital pulse circuit for maintaining a pulse width and suppressing noise according to the first aspect of the present invention;
Fig.14 shows an example of the construction of the digital pulse circuit for maintaining a pulse width and suppressing noise according to the second aspect of the present invention;
Fig.15 shows an example of the construction of the output-maintaining signal output portion 4; and
Fig.16 shows the operation of the circuit in Fig. 14.

### BEST MODE FOR CARRYING OUT THE INVENTION

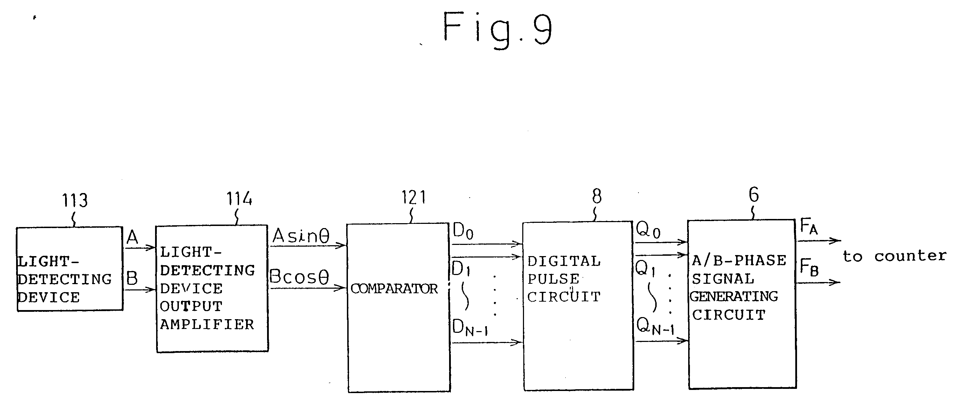

Figure 9 shows the construction of the digital pulse circuit for maintaining a pulse width and suppressing noise according to the present invention, applied to pulse encoder circuit to solve the aforementioned problem in the composition of FIG.4 as mentioned before.

In the construction of Fig.9, the digital pulse circuit 8 according to the present invention is inserted between the comparator of Fig.4 and the A/B-phase signal generating circuit 6.

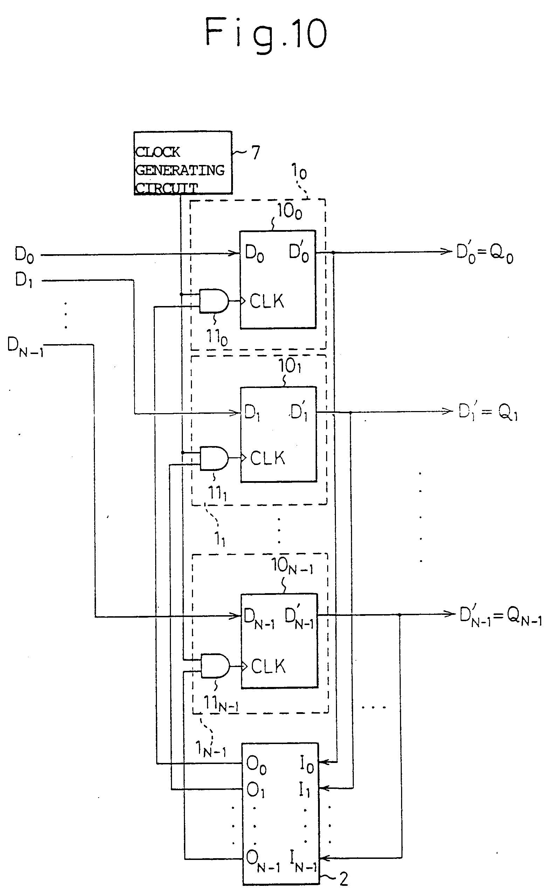

Figure 10 shows an example of the construction of the digital pulse circuit for maintaining a pulse width and suppressing noise according to the first aspect of the present invention.

The digital pulse circuit in Fig.10 is provided with a clock generator 7 which generates clock pulses having a cycle time longer than the minimum readable time interval in a counter ( 400ns in this embodiment ). In this counter, the output of the pulse encoder in which the digital pulse circuit according to the present invention is used, is counted. In addition, the abovementioned digital pulse circuit has N clock-synchronizing portions 1₀,1₁, ··· 1_{N-1} and an enable signal output portion 2. Each of the N clock synchronizing portions synchronizes the corresponding one of the N outputs D₀, D₁, ··· D_{N-1} from the aforementioned comparator 121 in Fig.9 by the clock pulse mentioned above. The enable signal output portion 2 receives N outputs D₀ ′ , D₁ ′ , ··· D_{N-1} ′ from the abovementioned N clock-synchronizing portions 1₀,1₁, ··· 1_{N-1}, at N input terminals I₀, I₁, ··· I_{N-1} respectively. At N output terminals 0₀, 0₁, ··· 0_{N-1} of the enable signal output portion 2, the corresponding output signal to each of these input signals appears. The enable signal output portion 2 recognizes two signals one of which can change its state ( rise to high level or fall to low level ) in the next operation, among the aforementioned N digital signals D₀, D₁, ··· D_{N-1}, and the enable signal output portion 2 outputs the enable signals which enable only the above two signals to enter the abovementioned N clock-synchronizing portions 1₀,1₁, ··· 1_{N-1}. The N signals D₀ ′ , D₁ ′ , ··· D_{N-1} ′ are obtained by synchronizing each of the N signals D₀, D₁, ··· D_{N-1} by the abovementioned clock pulse, where the N signals D₀, D₁, D_{N-1}, as shown in FIG.5, invert their levels every time a constant quantity of change in the objective quantity to be measured occurs, and phase differences between any successive signals among these N signals D₀, D₁, ··· D_{N-1} correspond to about (including the aforementioned fluctuation in the output wave from the light-detecting device ) 1/N of the abovementioned constant quantity. The enable signal output portion 2 recognizes the states of the signals D₀ ′, D₁ ′ , ··· D_{N}-₁ ′ at any timing. For example, if D₀ ′ =D₁ ′ = ··· =D ᵢ ′ =0, and D ᵢ₊₁ ′ = ··· =D _{N-1} ′ =1 ( i=0,1, ···N-2 ) the two signals, either of which can change its state in the next operation among the aforementioned N digital signals D₀, D₁, ··· D_{N-1}, are D ᵢ ( 0→1), and D ᵢ₊₁ ( 1 →0). In correspondence with this recognition, the enable signal output portion 2 outputs "1" from the output terminals 0 ᵢ and 0 ᵢ₊₁ among the aforementioned N output terminals 0₀, 0₁, ··· 0_{N-1}, and outputs "0" from the other terminals except 0 ᵢ and 0 ᵢ₊₁.

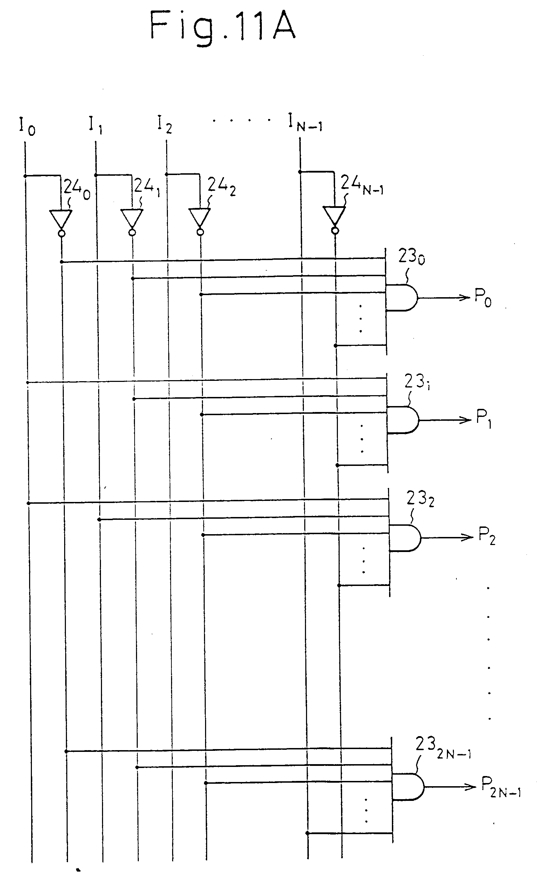

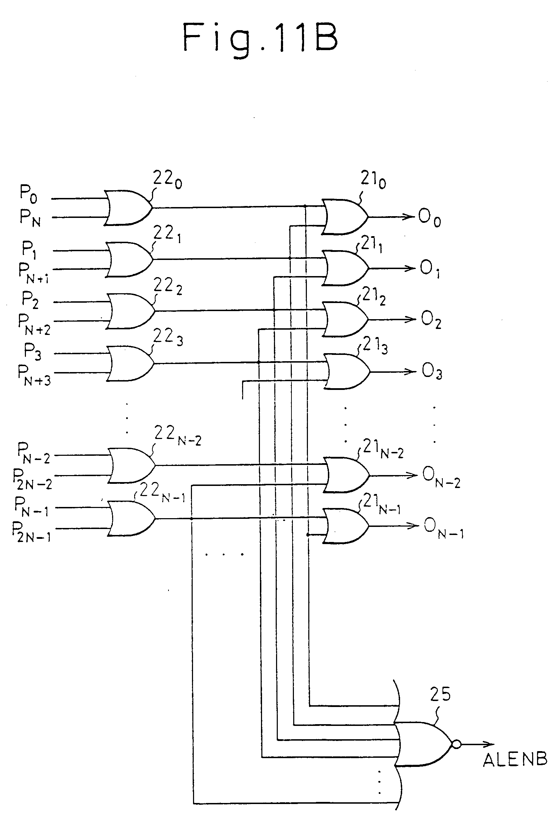

It will be readily understood that the enable signal output portion 2 in Fig.10 as mentioned above, can be realized by the construction shown in Fig.11A and Fig.11B. Each of the signals P₀, P₁, P₂, ··· shown in Fig.11A, becomes "1" when the outputs ( D₀ ′ , D₁ ′, ··· D _{N-1} ′) of D-flip-flop circuits 10₀, 10₁, ···10_{N-1}, are ( 0,0,0, ···0 ), ( 1,0,0, ···0 ), ( 1,1,0, ···0 ) , · · · respectively, each of the signals P_{N-1}, P_{N} , P _{N+1}, ··· shown in Fig. 11A, becomes "1" when the outputs ( D₀ ′, D₁ ′ , ··· D_{N-1} ′ ) are ( 1,···1,0 ), ( 1, ···1 ), ( 0,1, ··· 1 ), · · · respectively, and each of the signals P_{2N-2}, P_{2N-1} shown in Fig.11A, becomes "1" when each of the outputs ( D₀ ′ , D₁ ′ ,··· D_{N-1} ′) is ( 0, ···0,1,1 ), ( 0, ···0,0,1 ), respectively. These signals P₀, P₁, ··· P _{N-1}, P_{N} , P _{N+1}, ···P_{2N-1} are obtained by the construction consists of N inverters 24₀, 24₁, ···24_{N-1} and 2N AND gates 23₀, 23₁,···23_{2N-1}, as shown in Fig.11A. In the composition of Fig.11A, when P ₀ ="1" or P _{N} ="1", the signals which can change its state in the next operation among D₀, D₁, ··· D_{N-1}, are D₀ and D _{N-1}; when P ₁ ="1" or P _{N+1} ="1", the signals which can change its state in the next operation among D₀, D₁,··· D_{N-1}, are D ₀ and D₁; and when P ᵢ ="1" or P _{N+i} ="1", the signals which can change its state in the next operation among D₀, D₁, ··· D_{N-1}, are D ᵢ and D ᵢ₊₁. Therefore, the construction for obtaining output signals 0 ᵢ and 0 ᵢ₊₁, each of which enables the corresponding signal, D ᵢ or D ᵢ₊₁ to enter the next stage, respectively, is realized by using 2N OR gates 21₀, 21₁,···21_{N-1} and 22₀, 22₁, ···22 _{N-1} as shown in Fig.11B. In addition, in Fig.11B, a NOR gate 25, which receives all the outputs of the OR gates 22₀, 22₁, ···22_{N-1} , outputs all-enable signal ALENB which enables all signals of D₀, D₁, ··· D_{N-1} in FIG.10 to enter the next stage, when none of P₀, P₁, ··· P_{N-1}, P_{N} , P _{N+1}, ···P_{2N-1} equals to "1", for example, at the time of "power-on" or the like. Actually, the logical sum ( not shown ) of each of the outputs 0₀, 0₁, ··· 0_{N-1} of the enable signal output portion 2 and the output of the NOR gate 25 shown in Fig.11B, instead of 0₀, 0₁,··· 0 _{N-1}, is applied to the AND gate 11₀, 11₁, ···11_{N-1} in Fig. 10, respectively.

Each of the clock-synchronizing portions 1₀,1₁, ··· 1_{N-1} consists of a D-flip-flop circuit 10 ᵢ and AND gate 11 ᵢ, and receives the corresponding signal D ᵢ (i=1···N-1) at the data input terminal of the corresponding D-flip-flop circuit 10 ᵢ . The true output D ᵢ ′ of the D-flip-flop circuit 10 ᵢ corresponds to the output Q ᵢ of the digital pulse circuit 8. The AND gate 11 ᵢ receives the clock pulse from the clock generator 7 at one of the input terminals, and another input terminal of the AND gate 11 ᵢ is connected to the corresponding output terminal 0 ᵢ of the enble signal output portion 2. The output terminal of the AND gate 11 ᵢ is connected to the edge-trigger terminal of the correspomding D-flip-flop circuit 10 ᵢ, and therefore, the clock pulse from the clock generator 7 is applied to the D-flip-flop circuit 10 ᵢ , only when the enable signal from the enable signal output portion 2 is applied to the AND gate 11 ᵢ . As the output of the D-flip-flop circuit 10 ᵢ does not change state unless receiving the leading edge of the clock pulse, the enable signal can be regarded as the signal which enables the clock pulse to enter the corresponding D-flip-flop 10 ᵢ . From the other point of the view, the enable signal can be regarded as the signal which enables the signal D ᵢ to enter the corresponding D-flip-flop 10 ᵢ , i.e. which enables the D-flip-flop circuit 10 ᵢ to respond to the input signal D ᵢ so that the D-flip-flop circuit 10 ᵢ can output D ᵢ ′ corresponding to the input signal D ᵢ .

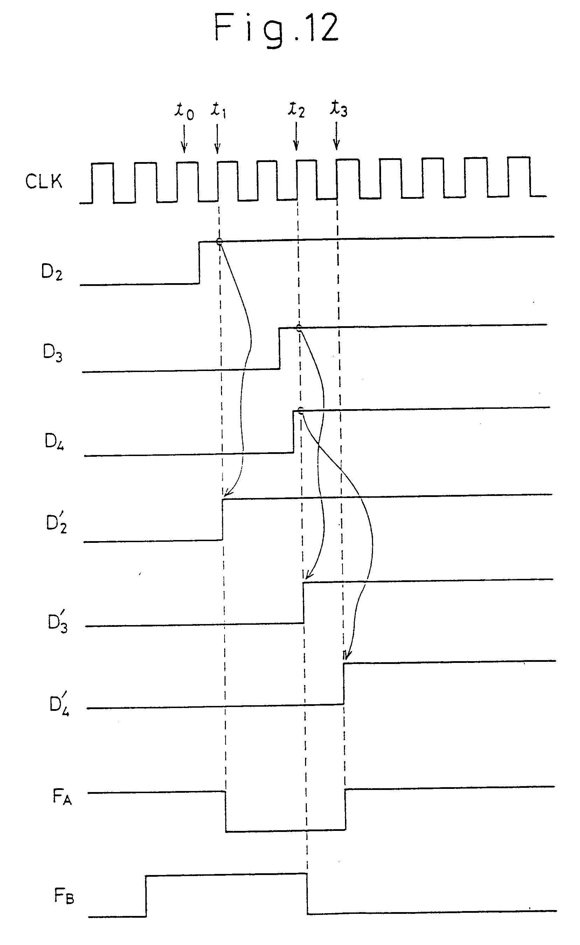

Referring now to a timing chart in Fig.12, the operation of the digital pulse circuit in Fig.10 is explained.

During the time from t₀ to t₁, the signal D₂ changes from 0 to 1. Therefore, at the time t₁, synchronized by the rising transition of the clock signal, the output signal D₂ ′ of the D-flip-flop circuit 10₂ to which the signal D₂ has been applied, changes from 0 to 1, because just before the time t₁, D₁ ′ = 1, and D₂ ′ =D₃ ′ = ··· =D _{N-1} ′ =0, so only D₁ ′ and D₂ ′ are enabled to change. Then, during the time from t₁ to t₂, the signals D₃ and D₄ change from 0 to 1. In this case, just before the time t₂, D₁ ′ = D₂ ′ = 1, and D₃ ′ =D₄ ′ = ··· =D _{N-1} ′ =0, so only D₂ ′ and D₃ ′ are enabled to change. Therefore, at the time t₂, the output D₄ ′ of the D-flip-flop circuit 10₄ does not respond to the input signal D₄, and only the output D₃ ′ of the D-flip-flop circuit 10₃ responds to the input signal D₃, and changes from 0 to 1. At the next rising timing of the clock pulse t₃, the output D₄ ′ of the D-flip-flop circuit 10₄ changes from 0 to 1. Even if a time interval exists between the timings of the transitions in any two signal levels among the N input signals applied to the construction of Fig.10, which is shorter than the cycle time of the clock pulse, the intervals between the timings of the transitions in any two signal levels among the N output signals D₀ ′, D₁ ′, ··· D_{N-1} ′ (which equals Q₀, Q₁, ··· Q_{N-1}) of the construction of Fig.10, are equal to or greater than the cycle time of the clock pulse, that is, the aforementioned minimum readable time interval. Therefore, the time intervals between the timings of the transitions in the output signals F _{A} , F _{B} are equal to or greater than the above cycle time, and consequently, Consequently, these signals can be counted by the counter (for example, in the NC apparatus) without misreading.

In addition, because only two input signals are enabled to enter the next stage at the same time among D ₀, D₁,··· D_{N-1}, the noise which superposes on any input signals except the above two enabled signals has no influence on the output signals D₀ ′, D₁ ′ , ··· D_{N-1} ′ of the construction of Fig.10.

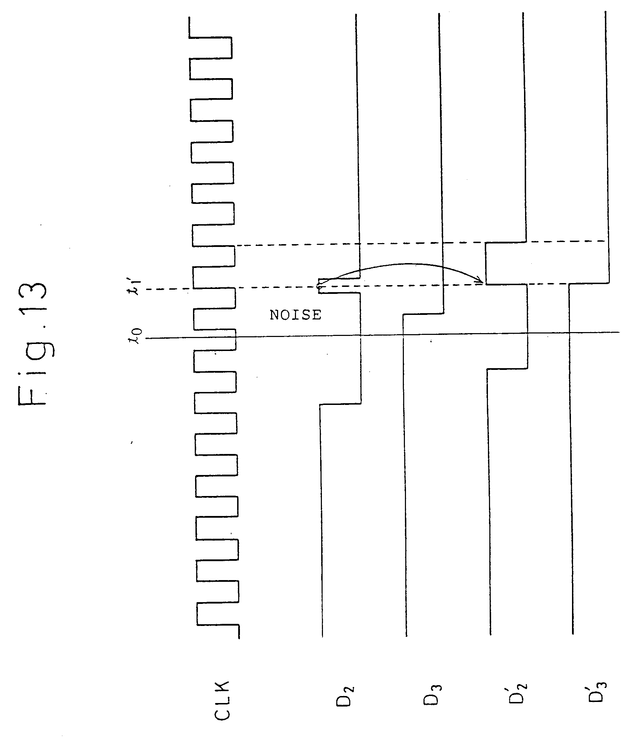

However, in the following special case, the abovementioned digital pulse circuit for maintaining a pulse width and suppressing noise according to the first aspect of the present invention, can not suppress some noise which appears at the timing mentioned below. This case is discussed with referrence to Fig.13.

In Fig.13, at the time t₀, only D₂ and D₃ are enabled, as mentioned before. In this situation, if the objective quantity to be measured increases (i.e. the time proceeds towards the right direction in Fig.13), at first, D₃ changes from 1 to 0 (Cf. D₃ in Fig.13). Then, at the timing of the next rising of the clock pulse, D₃ ′ changes from 1 to 0 (Cf. D₃ ′ in Fig.13). However, if a noise is superposed on the signal D₂, which is also enabled together with D₃ at the same timing as the abovementioned next rising time (Cf. D₂ in Fig.13), D₂ ′ also changes from 0 to 1 at this timing (Cf. D₂ ′ in Fig.13). This means that an abnormality appears in the signal due to the influence of the noise.

In order to remove the above abnormality, in the second aspect of the present invention; a first means (first kind of clock-synchronizing portion) which receives the aforementioned signals D₀ , D₁, ··· D_{N-1} and synchronizes each of the N digital signals by the clock pulse having cycle time is greater than the minimum readable time interval at the aforementioned counter; a second means (second kind of clock-synchronizing portion) which synchronizes once again each of the output signals from the first means by the above clock pulse; a third means which enables only two signals which can change states in the next change of the aforementioned objective quantity to be measured, among the input signals to the second means, to enter the second means; and a fourth means for detecting the existence of two signals having changed states (rise to high level or fall to low level) at the same time, among the outputs signals from the first means, and maintaining the output signals from the second means corresponding to the two signals, in the states just before the change, until one of said two signals returns to the state just before the change; are provided.

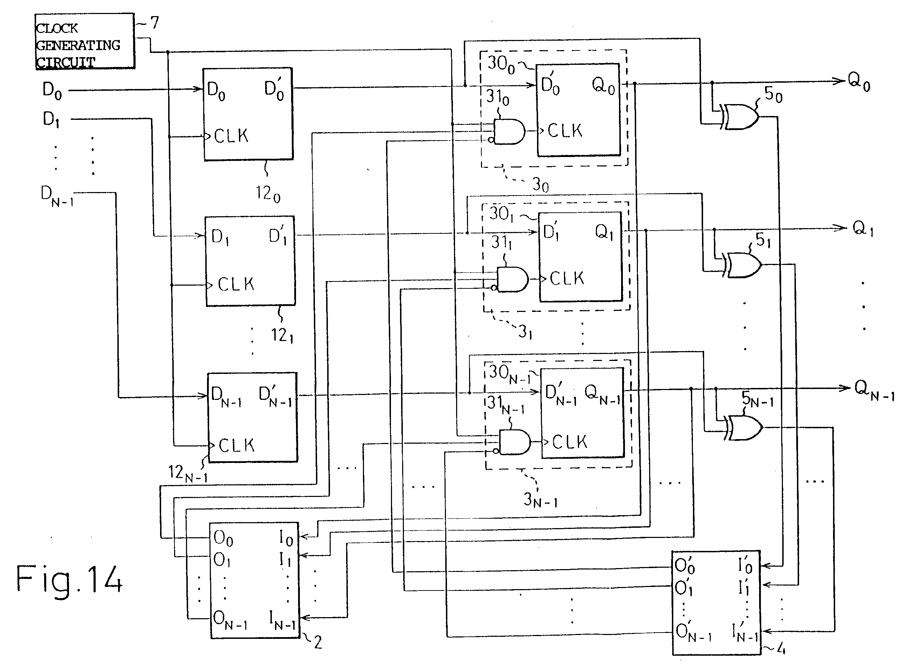

In the following part, the second aspect of the present invention is explained with referrence to Fig.14 which shows the construction of that embodiment.

The composition of Fig.14 comprises: a group of the first kind of clock-synchronizing portions 12₀ , 12₁, ···12_{N-1} provided for each of input signals D₀ , D₁, ··· D _{N-1}; a group of the second kind of clock-syncronizing portions 3₀ , 3₁, ··· 3_{N-1} provided for each of output signals D₀′, D₁ ′ , D_{N-1} ′ of the first kind of clock-syncronizing portions; an enable signal output portion 2 which receives each of the output signals Q₀ , Q₁,··· Q_{N-1} of the second kind of clock-syncronizing portions 3₀ , 3₁, ··· 3_{N-1} at the N input terminals I₀ , I₁, ··· I_{N-1}, and which outputs enable signals which enable only two signals which can change states (rise to high or fall to low) in the next operation, among the input signals D₀ ′, D₁ ′, ··· D_{N-1} ′ , to enter the corresponding one of the second kind of clock-synchronizing portions 3₀ , 3₁, ··· 3_{N-1}; leading edge-tailing edge detecting portions 5₀ , 5₁,··· 5_{N-1} each of which detects leading edges or tailing edges of the corresponding one of the output signals D₀ ′, D₁ ′ , ··· D _{N-1} ′ of the first kind of clock-synchronizing portions, by comparing the above corresponding one of the output signals D₀ ′ , D₁ ′ , ··· D_{N-1}′ with the corresponding one of the output signals Q₀ , Q₁, ··· Q_{N-1} of the second kind of clock-synchronizing portions 3₀ , 3₁, ··· 3_{N-1}; an output-maintaining signal output portion 4 which receives the outputs of the leading edge-tailing edge detecting portions 5₀ , 5₁, ··· 5_{N-1}, and which detects that two signals D ₖ ′ , D ₗ ′ have changed states (rise to high level or fall to low level) at the same time, among the outputs signals D₀′ , D₁ ′, ··· D_{N-1} ′, and then outputs the signals which maintain the output signals Q ₖ, Q ₗ of the second kind of clock-synchronizing portions 3 ₖ, 3 ₗ corresponding to the above two signals D ₖ ′, D ₗ ′ , in the states just before the change, until one of the two signals D ₖ ′ , D ₗ ′ returns to the state just before the change; and a clock pulse generator 7 which generates clock pulses having cycle time longer than the minimum readable time interval at the counter which counts the output signals of the pulse encoder.

Each of the N first kind of clock-synchronizing portions 12₀ , 12₁, ···12_{N-1} is realized by using a D-flip-flop circuit respectively, and each of the N second kind of clock-synchronizing portions 3₀ , 3₁, ··· 3_{N-1} is realized by using the corresponding combination of D-flip-flop circuits 30₀, 30₁, ···30_{N-1} and AND gates 31₀ , 31₁,···31_{N-1} respectively, in the construction of Fig.14.

Each of the aforementioned input signals D₀ , D₁, ··· D_{N-1} is applied to the data input terminals of the corresponding D-flip-flop circuit which realizes the corresponding one of the first kind of clock-synchronizing portions 12₀ , 12₁, ···12_{N-1}, respectively, and the clock pulse from the clock pulse generator 7 is applied to the edge-trigger terminal of each of the D-flip-flop circuits. Then, synchronizing with the clock pulse, each of the D-flip-flop circuits outputs the corresponding one of the true output signals D₀ ′ , D₁ ′ , ··· D_{N-1} ′ .

Each of the output signals D₀ ′ , D₁ ′ , ··· D_{N-1} ′ of the correspondiong one of the first kind of clock-synchronizing portions 12₀ , 12₁, ··· 12 _{N-1} is applied to the data input terminals of the corresponding D-flip-flop circuit 30₀, 30₁, ··· 30 _{N-1}, then these D-flip-flop circuits 30₀, 30₁, ··· 30 _{N-1} output the true output signals D₀ ′ , D₁ ′ , ··· D_{N-1} ′ , and each output of the AND gates 31₀ , 31₁, ··· 31 _{N-1} is applied to the edge-trigger terminal of the corresponding one of the D-flip-flop circuits 30₀, 30₁, ··· 30 _{N-1}. To each of the AND gates 31₀, 31₁, ··· 31 _{N-1}, the clock pulse from the abovementioned clock pulse generator 7, the output from the corresponding one of the N output terminals 0₀ , 0₁, ··· 0_{N-1} in the enable signal output portion 2, and the inverted signal of the output from the corresponding one of the N output terminals 0₀ ′, 0₁ ′ , ··· O_{N-1} ′ , are applied. In this construction, the clock pulse is applied to each of the D-flip-flop circuits 30₀, 30₁, ··· 30 _{N-1} only when the corresponding enable signal is active ("1") and the corresponding output-maintaining signal is non-active ("0"), that is, only under this condition is the corresponding signal D ᵢ ′ enabled.

The enable signal output portion 2 is realized by the construction of Fig.11A and Fig.11B, as in the aforementioned construction of Fig.10.

Each of the leading edge-tailing edge detecting portions 5₀ , 5₁, ··· 5_{N-1} comprises an EOR gate. To one terminal of each of the EOR gates 5₀ , 5₁,··· 5_{N-1}, the corresponding one of the outputs D₀ ′, D₁ ′, ··· D_{N-1} ′ of the mentioned first kind of clock-synchronizing portions 12₀, 12₁, ··· 12 _{N-1} is applied, and to another terminal of each of the EOR gates 5₀ , 5₁, ··· 5_{N-1}, the corresponding one of the outputs Q₀, Q₁, ··· Q _{N-1} of the mentioned second kind of clock-synchronizing portions 3₀, 3₁, ··· 3 _{N-1} is applied. For example, if D ᵢ ′ among the above signals D₀ ′, D₁ ′ , ··· D_{N-1} ′ , changes state, since the corresponding output signal Q ᵢ changes state at the timing of the next rising of the clock pulse in the corresponding second kind of clock-synchronizing portions 3 ᵢ , until that rising time, D ᵢ ′ ≠ Q ᵢ, the output of the EOR gates 5 ᵢ is "1". Therefore, the leading edge or the tailing edge of D ᵢ ′ can be detected.

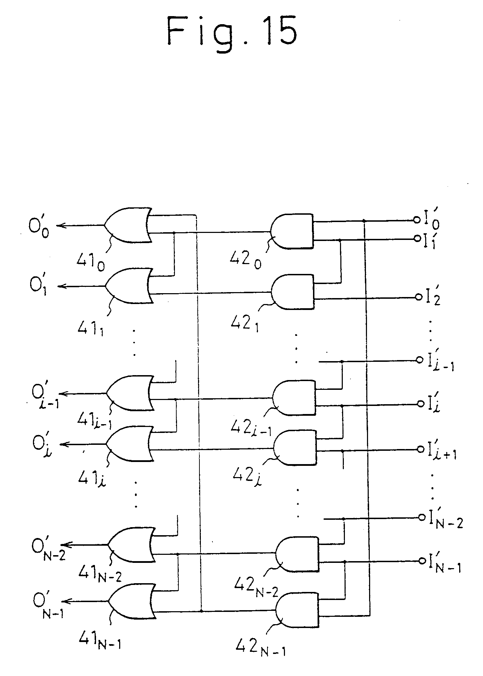

The detailed construction of the output-maintaining signal output portion 4 is shown in Fig.15. Since, owing to the operation of the enable signal output portion 2, only the two signals adjacent to each other in the order of phase progress, for example, D ᵢ ′ and D ᵢ₊₁ ′ (including the case of D _{N-1}′ and D ₀ ′ ), can become enabled (change states ) at the same time; the output-maintaining signal output portion 4 in Fig. 15 is composed of: a row of AND gates 42₀, 42₁, ··· 42 _{N-} ₁ each of which detects the two adjacent outputs having levels "1" at the same time, among the N outputs of the mentioned N leading edge-tailing edge detecting portions 5₀ , 5₁, ··· 5_{N-1}; and a row of the OR gates 41₀, 41₁,··· 41 _{N-1} which outputs the output-maintaining signals to maintain the outputs Q ᵢ, Q ᵢ₊₁ of the second kind of clock-synchronizing portions 3 ᵢ , 3 ᵢ₊₁, to each of which the corresponding one of the two changed signals as mentioned above, D ᵢ ′ and D ᵢ₊₁ ′ is applied, where each changed signal makes the corresponding output of the leading edge-tailing edge detecting portions 5ᵢ, 5 ᵢ₊₁ to be "1".

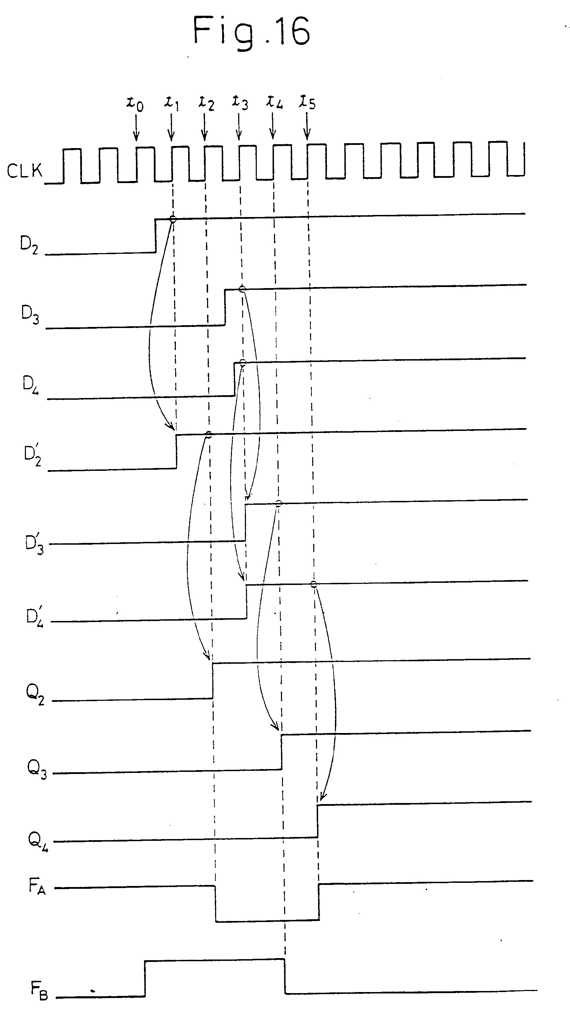

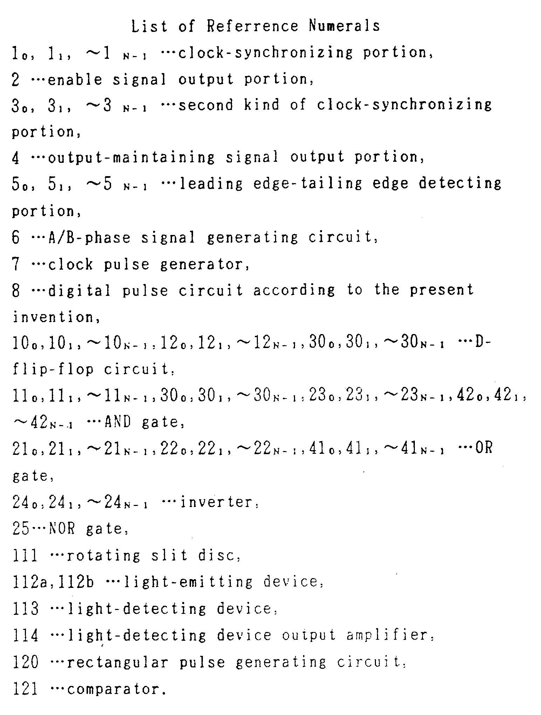

Referring to a timing chart of Fig.16, the operation of the digital pulse circuit of the construction as mentioned above, is explained as follows:

During the time interval from the timing t₁ and t₂, D₂ changes from 0 to 1. Then, at the time t₂, synchronizing with the rising of the clock pulse, the output D₂ ′ of the corresponding first kind of clock-synchronizing portions 12₂ changes from 0 to 1, and at the next timing of the rising of the clock pulse t₂, the output D₂ ′ of the corresponding second kind of clock-synchronizing portions 3₂ changes from 0 to 1. Since Q₀ = Q₁ = 1, Q₂ =Q₃=···=Q _{N-1} = 0 at the time of just before t₂, the enable signals having a "1" level are output from the output terminals 0₁ and 0₂ only in the enable signal output portion to enable D₁ ′ and D₂ ′ to enter the next stage, and consequently, only the signals D₁ ′ and D₂ ′ become enabled.

During the time interval from the timing t₂ and t₃, the input signals D₃ and D₄ change from 0 to 1. Then, at the time t₃, synchronizing with the rising of the clock pulse, the outputs D₃ ′ and D₄ ′ of the corresponding first kind of clock-syncronizing portions 12₃ and 12₄ change from 0 to 1, and at the next timing of the rising of the clock pulse t₄, the outputs D₃ ′ and D₄ ′ of the corresponding second kind of clock-synchronizing portions 3₃ and 3₄ change from 0 to 1. However, since Q₀=Q₁=Q₂= 1, Q₃ =Q₄=···=Q _{N-1} =0 at the time of just before t₄,among D₀ ′ , D₁ ′ , ··· D_{N-1} ′ , the signals which is enabled to enter the corresponding second kind of clock-syncronizing portions, i.e. which can change the output of the corresponding second kind of clock-syncronizing portions, are only D₂ ′ and D₃ ′ . Therefore, at the next timing of rising of the clock pulse t₄, only the output Q₃ of the second kind of clock-synchronizing portions 3₃, which corresponds to the signal D₃ ′ , changes from 0 to 1. After that, the outputs of the second kind of clock-synchronizing portions 3₀, 3₁, ··· 3 _{N-1} become Q₀=Q₁=Q₂=Q₃=1, Q₄ =Q₅=···=Q _{N-1} =0, and therefore, D₄ ′ is enabled. Then, at the next timing of the rising of the clock pulse t₅, the output Q₄ of the second kind of clock-synchronizing portions 3₅, also changes from 0 to 1. As mentioned above, also in the construction of Fig.14, even if a time interval exists between any timings of transitions in the N input signals D₀ , D₁, ··· D_{N-1}, shorter than the cycle time of the aforementioned clock pulse, the time interval between any timings of transitions in the N output signals Q₀ , Q₁, ··· Q_{N-1}, becomes longer than the cycle time of the clock pulse, that is, the aforementioned minimum readable time interval. Therefore, the time intervals between any timings of transitions in the output signals F _{A}, F _{B} , which are obtained by applying the abovementioned Q₀ , Q₁,··· Q_{N-1} to the A/B-phase signal generating circuit 6 in Fig,9, become longer than the abovementioned cycle time, so these signals F _{A}, F _{B} are readable at the counter ( for example, in the NC apparatus ).

In addition, in the construction of Fig.14, when the two signals which are enabled by the operation of the enable signals from the enable signals output portion 2, for example, D₂ ′ and D₃ ′ , change states at the same time; the corresponding leading edge-tailing edge detecting portion 5₂ and 5₃ detect these changes, and then the output-maintaining signal output portion 4 detects that both the outputs of the leading edge-tailing edge detecting portions 5₂ and 5₃ were changed to "1" at the same time. The output-maintaining signal output portion 4 outputs the output-maintainung signals to the corresponding second kind of clock-synchronizing portions 3₂ and 3₃, so that the outputs Q₂ and Q₃ of these second kind of clock-synchronizing portions 3₂ and 3₃ are maintained. After that, when, for example, in the case of Fig.13, the noise superposed on the input signal D₂, disappears, the output D₂ ′ of the corresponding first kind of clock-synchronizing portion 12₂ returns to the proper level. Accordingly, the output of the corresponding leading edge-tailing edge detecting portion 5₂ becomes zero, and the above outputs of the output-maintaining signal output portion 4 becomes non-active ("0"). After that, the output Q₃ of the second kind of clock-synchronizing portions 3₂ can be changed properly according to the level of D₃ ′ .

As stated above, according to the second aspect of the present invention, all anticipated noise can be suppressed.

The inventers realized the circuit according to the present invention by using a gate array circuit.

### INDUSTRIAL APPLICABILITY

The digital pulse circuit according to the present invention is, in particular, useful as a means of obtaining incremental timing information with a high resolution from the output wave of the light-detecting portion in a high resolution pulse encoder.

## Claims

1. A digital pulse circuit which receives N input digital signals (D₀, D₁...D_{N-1}) in parallel, where N is an even integer equal to or greater than 4, the circuit comprising:
a clock pulse generator (7) which generates a clock pulse having a predetermined cycle time; and,
first means (1₀, 1₁...1_{N-1}; 3₀, 3₁...3_{N-1}) for accepting the N input digital signals, synchronising each of the N input digital signals with the clock pulse, and holding the level of each signal until a new signal is accepted, to output N synchronised digital signals (Q₀, Q₁ ...Q_{N-1}; characterised by:
second means (2; 11₀, 11, 11_{N-1}) for enabling only two of said N input digital signals (D₀, D₁...D_{N-1}) to be accepted by the first means in each clock cycle, said two digital signals being determined based on the immediately preceding levels of the N synchronised digital signals (D₀′, D₁′...D_{N-1}′).

2. A circuit according to claim 1, further comprising:
a third means (12₀, 12₁...12ₙ₋₁) for synchronising the input signals (D₀, D₁...Dₙ₋₁) with digital signals from the clock pulse prior to the input signals entering the first means; and,
a fourth means (4) for detecting an existence of two first synchronised digital signals, among the N synchronised digital signals (D₀′, D₁′...D_{N-1}′; Fig 14) output from the first means, the levels of which have changed during the same cycle of the clock pulse, the fourth means then controlling the first means to maintain the levels of two second synchronised digital signals among the N synchronised digital corresponding to said two first synchronised digital signals at the levels just before the levels of said two first synchronised digital signals changed, until one of said two first synchronised digital signals returns to a level just before the level of the two first synchronised digital signals changed.

3. A circuit according to claim 1, wherein the first means has a group of N clock-synchronising portions (1₀, 1₁...1_{N-1}) for the N input digital signals (D₀, D₁...D_{N-1}) respectively; and each of the N clock-synchronising portions (1₀, 1₁...1_{N-1}) synchronises a respective one of the N input digital signals (D₀, D₁...D_{N-1}) with the clock pulse.

4. A circuit according to claim 3, in which each of the N clock-synchronising portions (1₀, 1₁...1_{N-1}; 3₀, 3₁ ...3_{N-1}) comprises a D-flip-flop circuit.

5. A circuit according to claim 3, in which the second means receives N synchronised digital signals (D₀′, D₁′ ...D_{N-1}) from each of the group of N clock-synchronising portions (1₀, 1₁...1_{N-1}), and outputs N enable signals to be supplied to the N clock-synchronising portions, where two of the N enable signals are made active corresponding to the two digital signals to be enabled to enter the first means.

6. A circuit according to claim 5, in which each of the N clock-synchronising portions (1₀, 1₁...1_{N-1}) further comprises:
a D-flip-flop circuit (10₀, 10₁...10_{N-1}) for receiving one of the N input digital signals corresponding to each of the N clock-synchronising portions, and outputting one of the N synchronised digital signals corresponding to each of the N clock-synchronising portions; and,
a gate circuit (11₀, 11₁... 11_{N-1}) for receiving the clock pulse and one of the N enable signals corresponding to the each of the N clock-synchronising portions, and applying an output of the gate circuit to an edge-triggered input terminal of the D-flip-flop circuit in each of the N clock-synchronising portions.

7. A circuit according to claim 5, in which the second means comprises:
a first group of 2N gate circuits (23₀, 23₁...23_{N-1}) for receiving the N synchronised digital signals (D₀′, D₁′ ...D_{N-1}) from the N clock-synchronising portions (1₀, 1₁ ...1ₙ₋₁), detecting 2N possible conditions by determining 2N combinations of levels of the N output signals (D₀′, D₁′...D_{N-1}′) to output condition signals according to the detected conditions, respectively; and,
a second group of 2N gate circuits (21₀, 21₁...21_{N-1}) for receiving the condition signals and generating the N enable signals according to the condition signals.

8. A circuit according to claim 6, wherein the second means further comprises a third gate circuit (25) which receives all of the condition signals; and which outputs an all-enable signal (ALENB) which enables all of the N input digital signals (D₀, D₁...D_{N-1}) to enter the first means when the all of the condition signals are non-active.

9. A circuit according to claim 2, in which the first means comprises a second group of N clock-synchronising portions (3₀, 3₁...3_{N-1}), respectively provided corresponding to the N input digital signals, and each of the N clock-synchronising portions (3₀, 3₁...3_{N-1}) in the second group synchronises a corresponding one of the signals (D₀′, D₁′...D_{N-1}′) of the third means with the clock pulse.

10. A circuit according to claim 9, in which each of the N clock-synchronising portions (3₀, 3₁...3_{N-1}) in the second group is a D-flip-flop circuit.

11. A circuit according to claim 9, in which the second means receives the N second synchronised digital signals (Q₀, Q₁...Q_{N-1}) from the N clock-synchronising portions (3₀, 3₁...3_{N-1}) in the second group, and, when the synchronised signals change state, the second means outputs N enable signals to be supplied to the N clock-synchronised portions of the second group, where two of the N enable signals are made active corresponding to the two first synchronised digital signals to be enabled to be accepted by the first means.

12. A circuit according to claim 11, in which the second means further comprises a third group of 2N gate circuits (23₀, 23₁...23_{N-1}) for receiving the N second synchronised digital signals (Q₀, Q₁...Q_{N-1}) from the N clock-synchronising portions (3₀, 3₁...3_{N-1}) in the second group, detecting 2N possible conditions by determining 2N combinations of the levels of the the N second synchronised digital signals (Q₀, Q₁...Q_{N-1}) to output condition signals according to the detected conditions, respectively; and,
a fourth group of 2N gate circuits (21₀, 21₁...21_{N-1}) for receiving the condition signals and generating the N enable signals according to the condition signals.

13. A circuit according to claim 12, wherein the second means further comprises a third gate circuit (25) which receives all of the condition signals applied to the second group 2N gate circuit (21₀, 21₁...21_{N-1}); and which outputs an all-enable signal (ALENB) which enables all of the N input signals (D₀′, D₁′...D_{N-1}′) of the N second type of clock-synchronising portions (3₀, 3₁...3_{N-1}) to be accepted by the next stage, when the all of the condition signals are non-active.

14. A circuit according to claim 9, in which the fourth means comprises:
N leading edge/tailing edge detecting means (5₀, 5₁ ...5_{N-1}), respectively provided corresponding to the N input digital signals, each of the N leading edge/tailing edge detecting means comparing one of the first synchronising digital signals (D₀′, D₁′...D_{N-1}′) output from a corresponding one of the clock-synchronising portions (12₀, 12₁... 12_{N-1}) in the first group, with one of the second synchronised digital signals (Q₀, Q₁...Q_{N-1}) output from a corresponding one of the clock-synchronising portions (3₀, 3₁...3_{N-1}) in the second group to determine whether or not the compared ones of the first and second synchronised digital signals are equal to detect a pair of the compared one of the first and second synchronised digital signals in which one and the other of the pair are not equal; and,
an output-maintaining signal output portion (4) for outputting output-maintaining signals to two of the clock-synchronising portions (3₀, 3₁...3_{N-1}) in the second group which corresponds to two of the N leading edge/tailing edge detecting means (5₀, 5₁...5_{N-1}) when the two leading edge/tailing edge detecting means (5₀, 5₁...5_{N-1}) which are adjacent with regard to the order of the phase progress in due operation, and both of the two leading edge-tailing detecting means (5₀, 5₁...5_{N-1}) detect the pair, the output-maintaining signals making the two clock-synchronising portions in the second group maintain levels thereof, at levels just before the two leading edge/tailing edge detecting the pair, until one of the two first synchronised digital signals returns to a level just before the two leading edge/tailing edge detecting means detect the pair.

15. A circuit according to claim 14, in which each of the leading edge/tailing edge detecting means (5₀, 5₁...5_{N-1}) comprises an EOR gate.

16. A circuit according to claim 14, in which the output-maintaining signal output portion (4) comprises:
NAND gates (42₀, 42₁...42_{N-1}), provided corresponding to each two of the leading edge-tailing edge detecting means (5₀, 5₁...5_{N-1}), each of the NAND gates (42₀, 42₁ ...42_{N-1}) receives two output signals from the corresponding two of the leading edge-tailing edge detecting means (5₀, 5₁...5_{N-1}); and,
NOR gates (41₀, 41₁...41_{N-1}) provided corresponding to each leading edge/tailing edge detecting means (5₀, 5₁ ...5_{N-1}), each of the NOR gates (41₀, 41₁...41_{N-1}) outputs the logical sum of the outputs of two AND gates (42₀, 42₁ ...42_{N-1}) which receive the output of one of the N leading edge/tailing edge detecting means (5₀, 5₁...5_{N-1}).

## Patentansprüche

1. Schaltung für digitale Impulse, welche N digitale Eingangssignale (D₀0, D₁...D_{N-1}) parallel empfängt, wobei N eine ganze Zahl ist, die größer oder gleich 4 ist und wobei die Schaltung umfaßt:
einen Taktimpulsgenerator (7), welcher einen Taktimpuls mit einer vorgegebenen Zykluszeit erzeugt; und
erste Mittel (1₀, 1₁··· 1_{N-1}; 3₀, 3₁...3_{N-1}) zum Annehmen der N digitalen Eingangssignale, zum Synchronisieren jedes der N digitalen Eingangssignale mit dem Taktimpuls und zum Halten des Pegels jedes Signals, bis ein neues Signal angenommen wird, um N synchronisierte digitale Signale (Q₀, Q₁...Q_{N-1}) auszugeben; **gekennzeichnet durch**
zweite Mittel (2; 11₀, 11, 11_{N-1}) zum Freigeben von lediglich zwei der genannten N digitalen Eingangssignale (D₀, D₁...D_{N-1}), die während jedes Taktzyklus von den ersten Mitteln anzunehmen sind, wobei diese beiden digitalen Signale auf der Basis der unmittelbar vorausgehenden Pegel der N synchronisierten digitalen Signale (D′₀, D′₁...D′_{N-1}) bestimmt werden.

2. Schaltung nach Anspruch 1, ferner umfassend:
ein drittes Mittel (12₀, 12₁...12_{N-1}) zum Synchronisieren der Eingangssignale (D₀, D₁...D_{N-1}) mit digitalen Signalen von dem Taktimpuls (generator) vor dem Eintreten der Eingangssignale in die ersten Mittel; und
ein viertes Mittel (4) zum Detektieren des Vorhandenseins von zwei ersten synchroniserten Digitalsignalen unter den N synchronisierten Digitalsignalen (D′₀, D′₁...D′_{N-1}; Fig. 14), die von den ersten Mitteln ausgegeben werden und deren Pegel sich während desselben Zyklus des Taktimpulses geändert haben, wobei das vierte Mittel dann die ersten Mittel steuert, um die Pegel der beiden zweiten synchronisierten Digitalsignale unter den N synchronisierten Digitalsignalen aufrechtzuerhalten, die den beiden ersten synchronisierten Digitalsignalen entsprechen, und zwar auf den Pegeln unmittelbar bevor die Pegel der beiden genanten ersten synchronisierten Digitalsignale sich geändert haben, bis eines dieser beiden ersten synchronisierten Digitalsignale auf einen Pegel zurückkehrt, unmittelbar ehe sich der Pegel der beiden ersten synchronisierten Digitalsignale geändert hat.

3. Schaltung nach Anspruch 1, bei der die ersten Mittel eine Gruppe von N Taktsynchronisierteilen (1₀, 1₁, 1_{N-1}) für die einzelnen N digitalen Eingangssignale (D₀, D₁...D_{N-1}) besitzen und bei der jeder der N Taktsynchronisierteile (1₀, 1₁...1_{N-1}) jeweils das betreffende der N digitalen Eingangssignale (D₀, D₁...D_{N-1}) mit dem Taktimpuls synchronisiert.

4. Schaltung nach Anspruch 3, bei der jeder der N Taktsynchronisierteile (1₀, 1₁...1_{N-1}; 3₀, 3₁...3_{N-1}) eine D-Flip-Flop-Schaltung umfaßt.

5. Schaltung nach Anspruch 3, bei der die zweiten Mittel die N synchronisierten Digitalsignale (D′₀, D′₁...D_{N-1}) von jedem Teil der Gruppe von N Taktsynchronisierteilen (1₁, 1₁...1_{N-1}) empfangen und N Freigabesignale ausgeben, die den N Taktsynchronisierteilen zuzuführen sind, wobei zwei der N Freigabesignale entsprechend den beiden freizugebenden Digitalsignalen aktiviert werden, um in die ersten Mittel einzutreten.

6. Schaltung nach Anspruch 5, bei der jeder der N Taktsynchronisierteile (1₀, 1₁...1_{N-1}) ferner umfaßt:
eine D-Flip-Flop-Schaltung (10₀, 10₁...10_{N-1}) zum Empfangen jeweils eines der N digitalen Eingangssignale, die jedem einzelnen Teil der N Taktsynchronisierteile entsprechen und zum Ausgeben eines der N synchronisierten Digitalsignale, welches den einzelnen Teilen der N Taktsynchronisierteile entspricht; und
eine Gatterschaltung (11₀, 11₁...11_{N-1}) zum Empfangen des Taktimpulses und eines der N Freigabesignale, die den einzelnen Teilen der N Taktsynchronisierteile entsprechen und zum Anlegen eines Ausgangssignals der Gatterschaltung an einen flankengetriggerten Eingangsanschluß der D-Flip-Flop-Schaltung in jedem der N Taktsynchronisierteile.

7. Schaltung nach Anspruch 5, bei der die zweiten Mittel umfassen:
eine erste Gruppe von 2N Gatterschaltungen (23₀, 23₁...23_{N-1}) zum Empfangen der N synchronisierten Digitalsignale (D′₀, D′₁...D′_{N-1}) von den N Taktsynchronisierteilen (1₀, 1₁...1_{N-1}), zum Detektieren von 2N möglichen Bedingungen durch Bestimmen von 2 N Kombinationen von Pegeln der N Ausgangssignale (D′₀, D′₁...D′_{N-1}) und zum Ausgeben von Bedingungssignalen entsprechend den jeweils detektierten Bedingungen; und
eine zweite Gruppe von 2N Gatterschaltungen (21₀, 21₁...21_{N-1}) zum Empfangen der Bedingungssignale und zum Erzeugen der N Freigabesignale entsprechend den Bedingungssignalen.

8. Schaltung nach Anspruch 6, bei der die zweiten Mittel ferner eine dritte Gatterschaltung (25) umfassen, welche alle Bedingungssignale empfängt und welche ein Signal "alles freigeben (ALENB) erzeugt, welches sämtliche N digitalen Eingangssignale (D₀, D₁...D_{N-1}) freigibt, um in die ersten Mittel einzutreten, wenn sämtliche Bedingungssignale nicht aktiv sind.

9. Schaltung nach Anspruch 2, bei der die ersten Mittel eine zweite Gruppe von N Taktsynchronisierteilen (3₀, 3₁...3_{N-1}) umfassen, die jeweils entsprechend den N digitalen Eingangssignalen vorgesehen sind, und bei der jeder der N Taktsynchronisierteile (3₀, 3₁...3_{N-1}) in der zweiten Gruppe das entsprechende unter den Signalen (D′₀, D′₁...D′_{N-1}) des dritten Mittels mit dem Taktimpuls synchronisiert.

10. Schaltung nach Anspruch 9, bei der jeder N Taktsynchronisierteile (3₀, 3₁...3_{N-1}) in der zweiten Gruppe eine D-Flip-Flop-Schaltung ist.

11. Schaltung nach Anspruch 9, bei der die zweiten Mittel die N zweiten synchronisierten Digitalsignale (Q₀, Q₁...Q_{N-1}) von den N Taktsynchronisierteilen (3₀, 3₁...3_{N-1}) in der zweiten Gruppe empfangen und bei der die zweiten Mittel dann, wenn die synchronisierten Signale ihren Zustand ändern, N Freigabesignale ausgeben, die den N Taktsynchronisierteilen der zweiten Gruppe zuzuführen sind, wobei zwei der N Freigabesignale aktiviert werden, die denjenigen beiden ersten synchronisierten Digitalsignalen entsprechen, die freizugeben sind, um von den ersten Mitteln angenommen zu werden.

12. Schaltung nach Anspruch 11, bei der die zweiten Mittel ferner eine dritte Gruppe von 2N Gatterschaltungen (23₀, 23₁...23_{N-1}) umfassen, um die N zweiten synchronisierten Digitalsignale (Q₀, Q₁...Q_{N-1}) von den N Taktsynchronisierteilen (3₀, 3₁...3_{N-1}) in der zweiten Gruppe zu empfangen, um die 2N möglichen Bedingungen durch Bestimmen der 2N Kombinationen von Pegeln der N zweiten synchronisierten Digitalsignale (Q₀, Q₁...Q_{N-1}) zu detektieren und um Bedingungssignale entsprechend den jeweils detektierten Bedingungen auszugeben; und
eine vierte Gruppe von 2N Gatterschaltungen (21₀, 21₁...21_{N-1}) zum Empfangen der Bedingungssignale und zum Erzeugen der N Freigabesignale entsprechend den Bedingungssignalen.

13. Schaltung nach Anspruch 12, bei der die zweiten Mittel ferner eine dritte Gatterschaltung (25) umfassen, welche sämtliche Bedingungssignale empfängt, die an die zweite Gruppe von 2N Gatterschaltungen (21₀, 21₁...21_{N-1}) angelegt werden und welche ein Signal "alles freigeben" (ALENB) ausgibt, welches alle N Eingangssignale (D′₀, D′₁...D′_{N-1}) der N Teile des zweiten Typs von Taktsynchronisierteilen (3₀, 3₁...3_{N-1}) freigibt, die von der nächsten Stufe anzunehmen sind, wenn alle Bedingungssignale nicht aktiv sind.

14. Schaltung nach Anspruch 9, bei der das vierte Mittel umfaßt:
NVorderflanken/Rückflanken-Detektoreinrichtungen (5₀, 5₁...5_{N-1}), die entsprechend den N digitalen Eingangssignalen vorgesehen sind, wobei jede der NVorderflanken/Rückflanken-Detektoreinrichtungen eines der ersten synchronisierten Digitalsignale (D′₀ , D′₁...D′_{N-1}), welche von dem betreffenden Teil der Taktsynchronisierteile (12₀, 12₁...12_{N-1}) in der ersten Gruppe ausgegeben werden, mit einem der zweiten synchronisierten Digitalsignale (Q₀, Q₁...Q_{N-1}) vergleicht, die von einem entsprechenden Teil der Taktsynchronisierteile (3₀, 3₁...3_{N-1}) der zweiten Gruppe ausgegeben werden, um zu bestimmen, ob die jeweils miteinander verglichenen ersten und zweiten synchronisierten Digitalsignale gleich sind, um einem Paar von miteinander verglichenen ersten und zweiten synchronisierten Digitalsignalen zu detektieren, in dem das eine oder andere Signal des Paares nicht gleich ist; und
einen Ausgangsteil (4) zum Aufrechterhalten des Ausgangssignals zum Ausgeben von Signalen zum Aufrechterhalten des Ausgangssignals an zwei Teile der Taktsynchronisierteile (3₀, 3₁...3_{N-1}) in der zweiten Gruppe, welche den zwei Detektoreinrichtungen unter den N Vorderflanken/Rückflanken-Detektoreinrichtungen (5₀, 5₁...5_{N-1}) entsprechen, wenn die beiden Vorderflanken/Rückflanken-Detektoreinrichtungen (5₀, 5₁...5_{N-1}), welche einander in der Reihenfolge des Fortschreitens der Phasenlage bei ordnungsgemäßem Betrieb benachbart sind, und die beiden Vorderflanken/Rückflanken-Detektoreinrichtungen (5₀, 5₁...5_{N-1}) das Paar entdecken, wobei die Signale zum Aufrechterhalten des Ausgangssignals dafür sorgen, daß die beiden Taktsynchronisierteile in der zweiten Gruppe ihre Pegel beibehalten, und zwar auf den Pegeln unmittelbar vor der Detektierung des Paares durch die beiden Vorderflanken/Rückflanken-Detektoreinrichtungen, bis eines der beiden ersten synchronisierten Digitalsignale auf einen Pegel zurückkehrt, den es unmittelbar vor dem Detektieren des Paares durch die beiden Vorderflanken/Rückflanken-Detektoreinrichtungen hatte.

15. Schaltung nach Anspruch 14, bei der jede der Vorderflanken/Rückflanken-Detektoreinrichtungen (5₀, 5₁...5_{N-1}) ein Exklusiv- oder -Gatter umfaßt.

16. Schaltung nach Anspruch 14, bei der der Ausgansgsteil (4) zum Aufrechterhalten des Ausgangssignals umfaßt:
NAND-Gatter (42₀, 42₁...42_{N-1}), welche jeder der beiden Vorderflanken/Rückflanken-Detektoreinrichtungen (5₀, 5₁...5_{N-1}) entsprechen, wobei jedes der NAND-Gatter (42₀, 42₁...42_{N-1}) die beiden Ausgangssignale von den beiden entsprechenden Vorderflanken/Rückflanken-Detektoreinrichtungen (5₀, 5₁...5_{N-1}) empfängt; und
NOR-Gatter (41₀, 41₁...41_{N-1}), die entsprechend jeder der Vorderflanken/Rückflanken-Detektoreinrichtungen (5₀, 5₁...5_{N-1}) vorgesehen sind, wobei jedes der NOR-Gatter (41₀, 41₁...41_{N-1}) die logische Summe der Ausgangssignale von zwei UND-Gattern (42₀, 42₁...42_{N-1}) ausgibt, welche die Ausgangssignale einer der N Vorderflanken/Rückflanken-Detektoreinrichtungen (5₀, 5₁...5_{N-1}) empfangen.

## Revendications

1. Circuit à impulsions numériques recevant N signaux numériques d'entrée (D0, D1, ... DN-1) en parallèle, où N est un nombre entier pair égal ou supérieur à 4, le circuit comprenant:
un générateur de rythme (7) qui génère une impulsion d'horloge ayant un temps de cycle prédéterminé; et
un premier moyen (10, 11 ... 1N-1; 30, 31... 3N-1) pour accepter les N signaux numériques d'entrée, synchronisant chacun des N signaux numériques d'entrée avec l'impulsion d'horloge et maintenant le niveau de chaque signal jusqu'à ce qu'un nouveau signal soit accepté, et pour sortir N signaux numériques synchronisés (Q0, Q1...QN-1); caractérisé par :
un second moyen (2; 110, 111... 11N-1) pour permettre seulement à deux desdits N signaux numériques d'entrée (D0, D1...DN-1) d'être acceptés par ledit premier moyen pour chaque cycle d'horloge, lesdits deux signaux numériques étant déterminés sur la base des niveaux immédiatement précédant des N signaux numériques synchronisés (D0′, D1′...DN-1′).

2. Circuit selon la Revendication 1, comprenant en outre:
un troisième moyen (120, 121... 12N-1) pour synchroniser les signaux d'entrée (D0, D1...DN-1) avec les signaux numériques provenant de l'impulsion d'horloge avant que les signaux d'entrée n'entrent dans le premier moyen; et,
un quatrième moyen (4) pour détecter l'existence de deux premiers signaux numériques synchronisés, parmi les N signaux numériques synchronisés (D0′, D1′...DN-1′; Fig. 14) à la sortie du premier moyen, dont les niveaux ont changé pendant le même cycle de l'impulsion d'horloge, le quatrième moyen contrôlant alors le premier moyen pour maintenir les niveaux de deux deuxièmes signaux numériques synchronisés parmi les N signaux numériques synchronisés correspondant auxdits deux premiers signaux numériques synchronisés aux niveaux justes antérieurs aux niveaux desdits deux premiers signaux numériques synchronisés modifiés, jusqu'à ce que l'un desdits deux premiers signaux numériques synchronisés revienne au niveau juste antérieur au niveau desdits deux premiers signaux numériques synchronisés modifiés.

3. Circuit selon la Revendication 1, dans lequel le premier moyen possède un groupe de N parties de synchronisation (10, 11...1N-1) pour les N signaux numériques d'entrée (D0, D1...DN-1), respectivement; et dans lequel chacune des N parties de synchronisation (10, 11...1N-1) synchronise respectivement l'un des N signaux numériques d'entrée (D0, D1...DN-1) avec l'impulsion d'horloge.

4. Circuit selon la Revendication 3, dans lequel chacune des N parties de synchronisation (10, 11...1N-1); 30, 31...3N-1) comprend un circuit à bascules D.

5. Circuit selon la Revendication 3, dans lequel le second moyen reçoit N signaux numériques synchronisés (D0′, D1′...DN-1) provenant de chacune des parties du groupe de N parties de synchronisation (10, 11...1N-1), et envoie N signaux de validation destinés à être appliqués aux N parties de synchronisation, où deux des N signaux de validation sont rendus actifs, correspondant aux deux signaux numériques à valider pour être reçus par le premier moyen.

6. Circuit selon la Revendication 5, dans lequel chacune des N parties de synchronisation (10, 11...1N-1) comprend en outre:
un circuit à bascules D (100, 101...10N-1) destiné à recevoir l'un des N signaux numériques d'entrée correspondant à chacune des N parties de synchronisation, et à émettre l'un des N signaux numériques synchronisés correspondant à chacune des N parties de synchronisation; et,
un circuit porte (110, 111...11N-1) destiné à recevoir l'impulsion d'horloge et l'un des N signaux de validation correspondant à chacune des N parties de synchronisation, et à appliquer une sortie du circuit porte à une borne d'entrée déclenchée par front d'impulsion du circuit à bascules D dans chacune des N parties de synchronisation.

7. Circuit selon la Revendication 5, dans lequel le second moyen comprend:
un premier groupe de 2N circuits portes (230, 231...23N-1) destinés à recevoir les N signaux numériques synchronisés (D0′, D1′...DN-1) provenant des N parties de synchronisation (10, 11...1N-1), à détecter 2N états possibles en déterminant 2N combinaisons entre les niveaux des N signaux de sortie (D0′, D1′...DN-1′) pour envoyer des signaux d'état en fonction des états détectés, respectivement; et,
un second groupe de 2N circuits portes (210, 211...21N-1) destinés à recevoir les signaux d'état et à générer les N signaux de validation en fonction des signaux d'état.

8. Circuit selon la Revendication 6, dans lequel le second moyen comprend en outre un troisième circuit porte (25) qui reçoit tous les signaux d'état; et qui émet un signal de validation général (ALENB) qui valide l'entrée de tous les N signaux numériques d'entrée (D0, D1...DN-1) dans le premier moyen lorsque tous les signaux d'état sont passifs.

9. Circuit selon la Revendication 2, dans lequel le premier moyen comprend un second groupe de N parties de synchronisation (30, 31...3N-1), prévus pour correspondre respectivement aux N signaux numériques d'entrée, et dans lequel chacune des N parties de synchronisation (30, 31...3N-1) du second groupe synchronise l'un des signaux correspondant (D0′, D1′...DN-1′) du troisième moyen au moyen de l'impulsion d'horloge.

10. Circuit selon la Revendication 9, dans lequel chacune des N parties de synchronisation (30, 31...3N-1) du second groupe est un circuit à bascules D.

11. Circuit selon la Revendication 9, dans lequel le second moyen reçoit les N deuxièmes signaux numériques synchronisés (Q0, Q1...QN-1) provenant des N parties de synchronisation (30, 31...3N-1) du second groupe, et, lorsque les signaux synchronisés changent d'état, le second moyen émet N signaux de validation à appliquer aux N parties de synchronisation du second groupe, où deux des N signaux de validation sont rendus actifs, correspondant aux deux premiers signaux numériques synchronisés à valider pour être reçus par le premier moyen.

12. Circuit selon la Revendication 11, dans lequel le second moyen comprend en outre un troisième groupe de 2N circuits portes (230, 231...23N-1) destinés à recevoir les N deuxièmes signaux numériques synchronisés (Q0, Q1...QN-1) provenant des N parties de synchronisation (30, 31...3N-1) du second groupe, à détecter N états possibles en déterminant 2N combinaisons de niveaux entre les N deuxièmes signaux numériques synchronisés (Q0, Q1...QN-1) afin d'émettre des signaux d'état en fonction des états détectés, respectivement; et,
un quatrième groupe de 2N circuits portes (210, 211... 21N-1) destinés à recevoir les signaux d'état et à générer les N signaux de validation en fonction des signaux d'état.

13. Circuit selon la Revendication 12, dans lequel le second moyen comprend en outre un troisième circuit porte (25) qui reçoit tous les signaux d'état appliqués au second groupe de 2N circuits portes (210, 211...21N-1); et qui émet un signal de validation générale (ALENB) qui valide tous les N signaux d'entrée (DO′, D1′...DN-1′) des N parties de synchronisation (30, 31...3N-1) du second type pour être appliqués à l'étage suivant, lorsque tous les signaux d'état sont passifs.

14. Circuit selon la Revendication 9, dans lequel le quatrième moyen comprend:
N moyens de détection de bord avant/bord arrière (50,51...5N-1), prévus pour correspondre respectivement aux N signaux numériques d'entrée, chacun des N moyens de détection de bord avant/bord arrière comparant l'un des premiers signaux numériques synchronisés (D0′, D1′...DN-1′) provenant de la partie de synchronisation (120, 121...12N-1) correspondante du premier groupe, avec l'un des deuxièmes signaux numériques synchronisés (Q0, Q1...QN-1) provenant de la partie de synchronisation (30, 31...3N-1) correspondante du second groupe pour déterminer si oui ou non les signaux comparés parmi les premiers et les deuxièmes signaux numériques synchronisés sont égaux afin de détecter une paire parmi les premiers et les deuxièmes signaux numériques synchronisés comparés dans laquelle l'un et l'autre membre de la paire ne sont pas égaux; et,
une partie de sortie maintenant le signal de sortie (4) destiné à émettre des signaux de maintien du signal de sortie vers deux des parties de synchronisation (30, 31...3N-1) du second groupe qui correspond à deux des N moyens de détection de bord avant/bord arrière (50, 51...5N-1) lorsque les deux moyens de détection de bord avant/bord arrière (50, 51...5N-1) qui sont adjacents par rapport à l'ordre de progression de la phase pendant le fonctionnement normal, et les deux moyens de détection de bord avant/bord arrière (50, 51...5N-1) détectent la paire, les signaux de maintien du signal de sortie maintenant les niveaux des deux parties de synchronisation du second groupe à des niveaux juste antérieurs à la détection de la paire par les deux moyens de détection bord avant/bord arrière, jusqu'à ce que l'un des deux premiers signaux numériques synchronisés retourne à un niveau juste antérieur à la détection de la paire par les deux moyens de détection de bord avant/bord arrière.

15. Circuit selon la Revendication 14, dans lequel chacun des moyens de détection de bord avant/bord arrière (50, 51...5N-1) comprend une porte OU exclusif.

16. Circuit selon la Revendication 14, dans lequel la partie de sortie maintenant le signal de sortie (4) comprend:
des portes NON-ET (420, 421...42N-1), prévues pour correspondre à chacun des deux moyens de détection de bord avant/bord arrière(50, 51...5N-1), chacune des portes NON-ET (420, 421...42N-1) recevant deux signaux de sortie provenant des deux moyens de détection de bord avant/bord arrière (50, 51...5N-1) correspondants; et,
des portes NON-OU (410, 411...41N-1), prévus pour correspondre à chacun des moyens de détection de bord avant/bord arrière (50, 51... 5N-1), chacune des portes NON-OU (410, 411... 41N-1) émettant la somme logique des sorties de deux portes ET (420, 421...42N-1) qui reçoivent le signal de sortie de l'un des N moyens de détection de bord avant/bord arrière (50, 51...5N-1).
